# EUROPÄISCHE PATENTSCHRIFT

(11) **EP 3 083 159 B1**
(45) Veröffentlichungstag und Bekanntmachung des Hinweises auf die Patenterteilung: **08.07.2020**
(21) Anmeldenummer: 14761625.4
(22) Anmeldetag: 08.09.2014
(51) Int. Cl.: B25J 9/16, H05K 13/04

(54) **POSITIONIEREINRICHTUNG**
POSITIONING DEVICE
DISPOSITIF DE POSITIONNEMENT

(30) Priorität: 18.12.2013 DE 102013226448
(43) Veröffentlichungstag der Anmeldung: 26.10.2016
(73) Patentinhaber: ETEL S.A., 2112 Môtiers (CH)
(72) Erfinder: MAZEROLLE, Hélène, CH-1453 Mauborget (CH); VAUCHER, Jean-Marc, CH-2108 Couvet (CH); KUNZE, Marc, CH-1373 Chavornay (CH); HEINIGER, Laurent, CH-2000 Neuchâtel (CH)
(74) Vertreter: Pleyer, Hans Anno
(86) Internationale Anmeldenummer: PCT/EP2014/069032
(87) Internationale Veröffentlichungsnummer: WO 2015/090652

(56) Entgegenhaltungen:
- EP-A1- 2 002 945
- EP-B1- 2 066 996
- DE-A1- 4 425 924
- JP-A- 2002 289 647
- DEGOULANGE E ET AL: "Determination of a force control law for an industrial robot in contact with a rigid environment", PROCEEDINGS OF THE INTERNATIONAL CONFERENCE ON SYSTEMS, MAN AND CYBERNETICS. LE TOUQUET, OCT. 17 - 20, 1993; [PROCEEDINGS OF THE INTERNATIONAL CONFERENCE ON SYSTEMS, MAN AND CYBERNETICS], NEW YORK, IEEE, US, Bd. -, 17. Oktober 1993 (1993-10-17), Seiten 270-275, XP010132130, DOI: 10.1109/ICSMC.1993.384882 ISBN: 978-0-7803-0911-1
- LEE K-M ET AL: "Design and control of a spherical air-bearing system for multi-d.o.f. ball-joint-like actuators", MECHATRONICS, PERGAMON PRESS, OXFORD, GB, Bd. 13, Nr. 2, 1. März 2002 (2002-03-01), Seiten 175-194, XP004389420, ISSN: 0957-4158, DOI: 10.1016/S0957-4158(01)00037-X

## Beschreibung

Die vorliegende Erfindung betrifft eine Positioniereinrichtung zur Bearbeitung eines Werkstücks oder zur Platzierung von Komponenten in einer Ebene. Solche Positioniereinrichtungen dienen beispielsweise dazu, elektronische Komponenten auf einer Leiterplatte zu positionieren, oder auch um flache Werkstücke mit einem Werkzeug zu bearbeiten.

Aus der EP 2066996 B1 ist eine Positioniereinrichtung in Portalbauweise bekannt, bei der zwischen zwei parallelen Linearführungen ein Querbalken beweglich gelagert ist, auf welchem mittels einer weiteren Linearführung ein Funktionselement beweglich gelagert ist, so dass dieses Funktionselement in einer Ebene zwischen den beiden parallelen Linearführungen frei positionierbar ist. Als Funktionselement kommt hier beispielsweise ein Greifer eines Bestückungsautomaten, ein Laser eines Laser-Bearbeitungszentrums oder auch ein Tastsystem einer Koordinatenmessmaschine in Frage. Die genannte EP 2066996 B1 beschäftigt sich vor allem mit einer möglichst genauen Positionsmessung an solchen Positioniereinrichtungen, da eine genaue Positionierung des Funktionselementes oft sehr wichtig ist.

Auch die DE 102009008900 A1 beschäftigt sich mit solchen Positioniereinrichtungen in Portalbauweise. Diese sind aus verschiedenen Gründen regelungstechnisch nicht einfach zu beherrschen. Es wird daher eine Einrichtung zum Regeln einer Positioniereinrichtung offenbart, mit der eine besonders genaue Positionierung möglich ist.

Wenn das Funktionselement, das am Querbalken geführt und über dem Werkstück positioniert wird, eine erhebliche Kraft auf das Werkstück ausüben muss, so kann dies dazu führen, dass die Bestandteile der Positioniereinrichtung deformiert werden. Wegen der großen Hebel, die durch die Portalbauweise entstehen, können dabei schon kleine Verformungen zu einem erheblichen Versatz des Angriffspunktes des Werkzeugs am Werkstück führen, der für Anwendungen mit hoher Anforderung an die Positioniergenauigkeit inakzeptabel ist. Ein Beispiel für eine solche Anwendung ist das Thermokompressionsbonden, bei dem elektronische Komponenten mittels Druck und Temperatur mit einer Leiterplatte verbunden werden. Hierzu können Kräfte bis zu 500 N nötig sein. Andererseits sind in solchen und vergleichbaren Anwendungen geforderte Positioniergenauigkeiten im Bereich von einem Mikrometer und darunter nicht ungewöhnlich.

Besonders problematisch wirken sich solche großen Kräfte aus, wenn das Substrat, auf dem elektronische Komponenten platziert werden, nicht sehr genau waagrecht ausgerichtet ist, so dass die vertikale Prozesskraft nicht exakt senkrecht auf das Substrat ausgeübt wird. Die dadurch entstehenden lateralen Kräfte sind schon bei kleinen Verkippungen des Substrats nicht mehr akzeptabel. Außerdem muss auch die zu platzierende elektronische Komponente parallel zum Leiterplattensubstrat sein, was bei einer Verkippung des Substrats nicht mehr gewährleistet ist.

Aus dem Aufsatz "Determination of a force control law for an industrial robot in contact with a rigid environment", PROCEEDINGS OF THE INTERNATIONAL CONFERENCE ON SYSTEMS, MAN AND CYBERNETICS. LE TOUQUET, OCT. 17 - 20, 1993, und aus dem Dokument EP 2002945 A1 sind Roboter bekannt, die eine Minimierung unerwünschter Prozesskräfte ermöglichen. Hierzu sind aber jeweils aktiv ansteuerbare Achsen notwendig, die sowohl die Lage als auch die Orientierung eines Aktuators beeinflussen können. Dies ist mit einer Positioniereinrichtung in Portalbauweise mit lediglich drei linearen Achsen nicht möglich.

Mehrkomponenten - Kraftsensoren zur Messung von axialen und lateralen Kräften, die an einem Werkzeug mit axialer Vorzugsrichtung auftreten können, sind im Stand der Technik aus der EP2052810B1, der EP0594534B1 oder der JP-S-6128835A bekannt.

Es ist Aufgabe der Erfindung, eine Positioniereinrichtung zu schaffen, die trotz einer Verkippung eines Substrates, auf das eine Prozesskraft ausgeübt werden soll, eine genaue Positionierung eines Funktionselementes auf dem Substrat ermöglicht.

Diese Aufgabe wird gelöst durch eine Vorrichtung gemäß Anspruch 1. Vorteilhafte Details dieser Vorrichtung ergeben sich auch aus den von Anspruch 1 abhängigen Ansprüchen.

Es wird eine Positioniereinrichtung zum Positionieren eines Werkzeugs an einer Sollposition auf einem flächigen Substrat in einer X-Y-Ebene offenbart, das in seiner axialen Richtung eine Prozesskraft senkrecht auf das Substrat ausübt. Das Werkzeug ist mit einem Mehrkomponenten-Kraftsensor zur Messung von unerwünschten Prozesskraftkomponenten in lateraler Richtung ausgerüstet. Die Sollposition des Werkzeugs ist durch die Positioniereinrichtung so korrigierbar, dass die lateralen Prozesskraftkomponenten minimiert werden.

Übt nun das Werkzeug eine vertikale Kraft auf das flächige Substrat aus, und ist dieses Substrat leicht gegenüber seiner Soll-Lage parallel zur X-Y-Ebene verkippt, so werden die dadurch auftretenden, unerwünschten lateralen Prozesskraftkomponenten vom Mehrkomponenten-Kraftsensor erfasst. Dies erlaubt es, die Position des Werkzeuges so zu korrigieren, dass die lateralen Prozesskraftkomponenten verschwinden, ohne die Verkippung des Substrates vorab zu kennen. Da die Korrektur der Werkzeugposition erst erfolgt, wenn das Werkzeug das Substrat kontaktiert hat, kann die Korrektur so erfolgen, dass die Werkzeugspitze (und damit z.B. die zu platzierende Komponente) die Position auf dem Substrat beibehält. Die Achse des Werkzeugs wird stattdessen entsprechend der Verkippung des Substrates geneigt, so dass Substrat und Werkzeug wieder aufeinander senkrecht stehen. Es ist vorteilhaft, wenn diese Neigung des Werkzeugs durch ein Gelenk zwischen Werkzeug und Positioniereinrichtung ermöglicht wird, das zwar Kräfte in alle Richtungen, aber keinerlei Drehmomente überträgt. Gut geeignet ist hierzu beispielsweise ein Kugelelenk mit geringer Reibung, etwa dank einer Luftlagerung.

Die Positioniereinrichtung selbst kann das Werkzeug auf verschiedenste Arten positionieren. Neben Roboterarmen mit mehreren Freiheitsgraden oder mehrachsigen Werkzeugmaschinen kommen für die oben genannten Anwendungen vor allem Positioniereinrichtungen in Portalbauweise in Frage, die unten noch näher beschrieben werden.

Weitere Vorteile und Einzelheiten der vorliegenden Erfindung ergeben sich aus der nachfolgenden Beschreibung verschiedener Ausführungsformen anhand der Figuren. Dabei zeigt
- Figur 1: eine Positioniereinrichtung in Portalbauweise gemäß dem Stand der Technik,
- Figur 2: die Positioniereinrichtung der Figur 1 in einer Seitenansicht,
- Figur 3: ein Werkzeug beim Aufsetzen auf ein Substrat,
- Figur 4: eine erste Reglerstruktur zur Minimierung lateraler Prozesskräfte,
- Figur 5: eine zweite Reglerstruktur zur Minimierung lateraler Prozesskräfte.

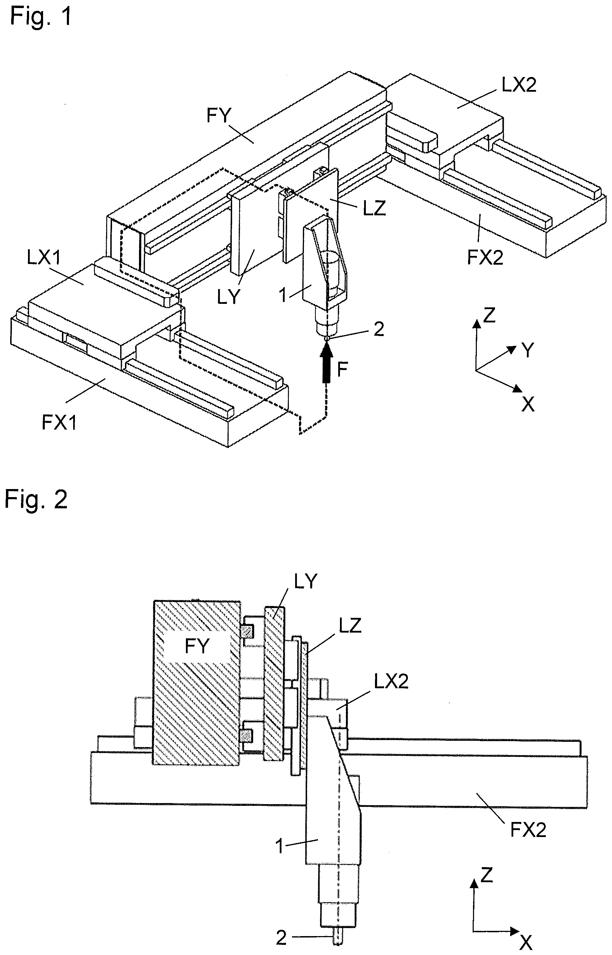

Die Figur 1 zeigt eine Positioniereinrichtung in Portalbauweise gemäß dem Stand der Technik. In einer X-Richtung liegen parallel zueinander zwei Linearführungen FX1, FX2 mit integrierten Linearantrieben, die zwei X-Laufwagen LX1, LX2 in X-Richtung beweglich halten. An den beiden Laufwagen LX1, LX2 befestigt ist eine Linearführung, die den Querbalken FY des Portalrahmens der Positioniereinrichtung bildet. Dieser Querbalken FY kann in X-Richtung über dem Arbeitsbereich zwischen den beiden Linearführungen FX1 und FX2 positioniert werden.

An der Linearführung FY ist ein Y-Laufwagen LY beweglich geführt, der mittels eines weiteren Linearantriebs zwischen den beiden Linearführungen FX1 und FX2 in Y-Richtung positioniert werden kann. Durch eine geeignete Ansteuerung der Antriebe in den Linearführungen FX1, FX2 und FY lässt sich der Y-Laufwagen LY frei über dem Arbeitsbereich zwischen den beiden Linearführungen FX1 und FX2 positionieren.

Der Y-Laufwagen LY trägt nun eine weitere Linearführung mit integriertem Antrieb, die einen Z-Laufwagen LZ in der Z-Richtung beweglich hält, die senkrecht auf die durch die X- und Y-Richtung aufgespannte Bearbeitungsebene steht.

Somit ist ein am Z-Laufwagen LZ befestigter Werkzeughalter 1 und ein von diesem gehaltenes Werkzeug 2 in allen drei Raumrichtungen X, Y und Z positionierbar. Beim Werkzeug 2 kann es sich beispielsweise um einen Greifer handeln, der ein elektronisches Bauelement aufnimmt und dieses auf eine im Arbeitsbereich abgelegte Leiterplatte setzt. Die hierfür nötige Kraft F wird vom Antrieb des Z-Laufwagens LZ aufgebracht. Da der Z-Laufwagen LZ in X-Richtung versetzt seitlich am Querbalken FY angeordnet ist, bewirkt diese vertikale Kraft F in Z-Richtung ein Drehmoment auf den Querbalken FY. Mit einer gestrichelten Linie ist in der Figur 1 die Kraftschleife eingezeichnet, die beim Aufsetzen des Werkzeugs 2 auf das in der X-Y-Ebene angeordnete Werkstück die Bestandteile der Positioniereinrichtung belastet.

Für das oben erwähnte Thermokompressionsbonden umfasst das Werkzeug 2 außerdem ein Heizelement, mit dem die elektronische Komponente innerhalb von wenigen Sekunden auf eine Temperatur oberhalb von 250 °C erhitzt werden kann, um das verwendet Lot zu schmelzen.

Die Figur 2 zeigt einen Schnitt durch die Positioniereinrichtung der Figur 1. Der Schnitt liegt in der X-Z-Ebene und verläuft durch den Z-Laufwagen LZ.

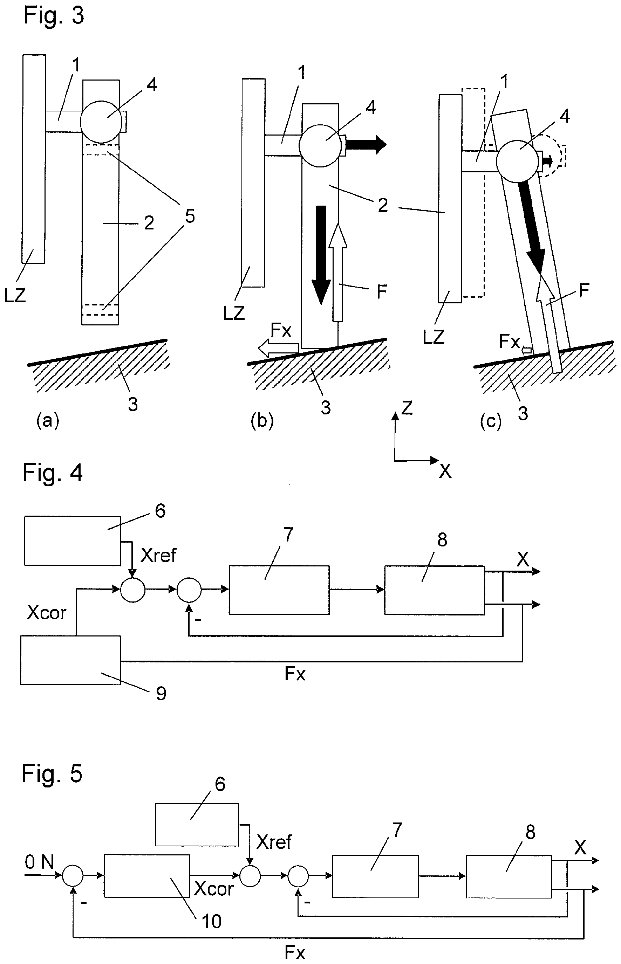

Figur 3 zeigt im Detail das Aufsetzen des Werkzeugs 2 auf ein Substrat 3, das in der X-Y-Ebene liegt, dabei aber leicht um die Y-Richtung verkippt ist. In der Figur ist die Verkippung übertrieben dargestellt, in der Realität sollte die Verkippung höchstens im Bereich von 0,01 Grad liegen. Aber auch solch kleine Winkel können bereits zu störenden lateralen Kräften führen.

In der Teilfigur 3(a) wird das Werkzeug 2 oberhalb des gewünschten Kontaktpunktes in X- und Y-Richtung (auf Sollkoordinaten Xref und Yref) platziert, bevor das Werkzeug dann in seiner axialen Richtung (der Z-Richtung) auf das Substrat 3 abgesenkt wird.

In der Teilfigur 3(b) hat das Werkzeug 2 das Substrat 3 berührt und beginnt, eine Kraft F auf das Substrat 3 auszuüben. Wegen der Verkippung des Substrats 3 ist die von der Positioniereinrichtung aufgebrachte Kraft (schwarzer Pfeil in axialer Richtung) versetzt gegenüber der vom Substrat ausgehenden Gegenkraft F (heller Pfeil in axialer Richtung). Dem dadurch bewirkten Drehmoment wirken laterale Kräfte Fx (schwarzer und heller Pfeil in lateraler Richtung) entgegen. Diese lateralen Kräfte werden nun mittels einem im Werkzeug 2 angeordneten Mehrkomponenten-Kraftsensor 5 erfasst. Bevorzugt sitzt der Mehrkomponenten-Kraftsensor 5 in der Nähe der Werkezugspitze, also z.B. in der Nähe der zu platzierenden elektronischen Komponente. Es sind aber wie in der Figur 3(a) angedeutet auch andere Positionen möglich.

In der Teilfigur 3(c) ist zu erkennen, dass nach einer Ausgleichsbewegung (vergleiche die aktuelle Position des Z-Laufwagens LZ mit der gestrichelt angedeuteten Position aus Teilfigur 3(b)) das Werkzeug 2 eine Verkippung erfahren hat, die der Verkippung des Substrates 3 entspricht, so dass das Werkzeug 2 nun genau senkrecht auf dem Substrat 3 steht. Eine zu platzierende elektronische Komponente ist damit wieder parallel zum Substrat 3. Die Prozesskraft F und ihre Gegenkraft liegen auf einer Linie, das zur Figur 3(b) beschriebene Drehmoment verschwindet. Entsprechend sind auch die lateralen Kräfte Fx sehr deutlich reduziert, sie entsprechen jetzt nur noch dem Sinus des Kippwinkels des Substrats 3, multipliziert mit der Prozesskraft F. Diese kleinen lateralen Kräfte müssen von den Antrieben der Positioniereinrichtung aufgebracht werden.

Während der Korrektur der Position des Werkzeugs 2 zum Minimieren der lateralen Kräfte Fx darf sich der Berührpunkt des Werkzeugs 2 am Substrat 3 nicht mehr ändern, denn sonst würde z.B. eine elektronische Komponente nicht mehr an der richtigen Stelle platziert. Die Reibungskraft zwischen Werkzeug 2 und Substrat 3 muss hierfür also groß genug sein. Nur so verkippt auch das Werkzeug 2 in der gewünschten Weise. Die Korrektur der Position wird daher beim Thermokompressionsbonden nach dem Aufsetzen der elektronischen Komponente auf das Substrat 3, aber noch vor oder jedenfalls während dem Erhitzen der Komponente durchgeführt, so dass die Korrektur abgeschlossen ist, bevor sich das eingesetzte Lot verflüssigt. Ein verflüssigtes Lot würde die Reibung zu stark herabsetzen, die noch nicht minimierten lateralen Kräfte Fx würden die Komponente auf dem Substrat 3 verschieben.

Der Werkzeughalter 1 muss zur Korrektur der Position dem Werkzeug 2 die nötigen Freiheitsgrade für eine Verkippung bieten. Dies kann schon durch eine gewisse Nachgiebigkeit des Werkzeughalters 1 erzielt werden. Vorteilhaft ist es aber, am Werkzeughalter 1 ein entsprechendes Gelenk 4 vorzusehen. Dieses Gelenk 4 sollte möglichst reibungsarm sein. Ein Kugelgelenk mit einer Luftlagerung hat sich hierfür als geeignet erwiesen und erlaubt Ausgleichsbewegungen in X- und Y-Richtung.

Typische, in Experimenten erhaltene Werte für die Kräfte sind bei einer Prozesskraft F von 500 N laterale Kräfte von 5 N ohne die Positionskorrektur des Werkzeugs 2 (entsprechend Teilfigur 3(b)), und 0,05 N mit einer solchen Korrektur (entsprechend Teilfigur 3(c)).

Ohne Beschränkung der Allgemeinheit zeigt die Figur 3 den Ausgleich einer lateralen Prozesskraft Fx in X-Richtung. Für Kräfte in Y-Richtung gelten die gleichen Überlegungen, beide Kräfte können bei entsprechender Verkippung des Substrats gleichzeitig auftreten und durch Korrekturen der Werkzeugposition in X- und Y-Richtung minimiert werden.

Die Figur 4 zeigt ein erstes Ausführungsbeispiel für einen Regelkreis, mit dem die lateralen Kräfte Fx minimiert werden können. Eine übergeordnete Steuerung 6 gibt bezüglich der X-Koordinate einen Sollwert Xref vor, der anhand eines Reglers 7 (z.B. ein PID-Regler) in der Positioniereinrichtung 8 eingestellt wird. Die tatsächliche Position X wird dabei gemessen und die Abweichung vom Sollwert Xref dem Regelkreis 7 zugeführt. Die unerwünschte laterale Prozesskraftkomponente Fx wird ebenfalls gemessen und einem Modell 9 der Positioniereinrichtung zugeführt, mit dessen Hilfe ein Korrekturwert Xcor für die Position des Werkzeugs 2 berechnet wird. Dieser Korrekturwert Xcor wird zum Sollwert Xref addiert. Auf diese Weise wird der Positioniereinrichtung eine Ausgleichsbewegung wie in der Figur 3(c) dargestellt eingeprägt.

In der Figur 5 ist ein weiteres Ausführungsbeispiel dargestellt, bei dem der Korrekturwert Xcor über einen zusätzlichen Lagekorrekturregler 10 erregelt wird. Hierzu wird dem Lagekorrekturregler 10 als Sollwert eine laterale Prozesskraftkomponente von 0 N vorgegeben, und von diesem Wert die tatsächlich gemessene Prozesskraftkomponente Fx abgezogen. Der wiederum als PID-Regler ausgebildete Lagekorrekturregler 10 erregelt dann den Korrekturwert Xcor, der wiederum zum Sollwert Xref addiert wird.

In den Figuren 4 und 5 ist lediglich eine Kraftkomponente in X-Richtung betrachtet, für die Y-Richtung gelten die gleichen Überlegungen. Die Erfindung wurde hier anhand der Messung der lateralen Prozesskraftkomponente Fx beschrieben. Da diese laterale Kraft Fx über einen Abstand vom Kraftangriffspunkt zu einem Drehpunkt (z.B. Gelenk 4) immer auch einem unerwünschten Drehmoment entspricht, lassen sich die Ausführungsbeispiele der Figuren 4 und 5 auch durch die Messung eines entsprechenden Drehmoments und die Verwendung desselben in einem Modell 9 oder einem Lagekorrekturregler 10 realisieren. Diese völlig gleichwertige, sich nur um den Faktor eines Abstands unterscheidende Alternative, sei von der Beschreibung oben und den folgenden Ansprüchen umfasst.

## Patentansprüche

1. Positioniereinrichtung zum Positionieren eines Werkzeugs (2) an einer Sollposition (Xref) auf einem flächigen Substrat (3) in einer X-Y-Ebene, das in seiner axialen Richtung (Z) eine Prozesskraft (F) senkrecht auf das Substrat (3) ausübt, wobei die Positioniereinrichtung in Portalbauweise ausgeführt ist, mit zwei parallelen Linearführungen (FX1, FX2) mit integrierten Linearantrieben, die je einen X-Laufwagen (LX1, LX2) in einer ersten Richtung (X) beweglich halten, sowie mit einem mit den beiden X-Laufwagen (LX1, LX2) verbundenen Querbalken (FY), der mittels eines integrierten Linearantriebs einen Y-Laufwagen (LY) in der zur ersten Richtung (X) senkrechten zweiten Richtung (Y) beweglich hält, sowie mit einem Werkzeughalter (1), der am Y-Laufwagen (LY) in der zur ersten und zweiten Richtung (X, Y) senkrechten Richtung (Z) geführt ist und das Werkzeug (2) zur Bearbeitung des in der X-Y-Ebene angeordneten Substrats (3) trägt, **dadurch gekennzeichnet, dass** das Werkzeug (2) mit einem Mehrkomponenten-Kraftsensor (5) zur Messung von unerwünschten Prozesskraftkomponenten (Fx) in lateraler Richtung (X, Y) ausgerüstet ist, die durch eine leichte Verkippung des Substrats (3) gegenüber seiner Soll-Lage parallel zur X-Y-Ebene entstehen, und dass die Sollposition (Xref) des Werkzeugs (2) durch Ausgleichsbewegungen der Linearantriebe der Positioniereinrichtung so korrigierbar ist, dass die lateralen Prozesskraftkomponenten (Fx) minimiert sind, wobei während der Ausgleichsbewegungen eine Werkzeugspitze die Position auf dem Substrat (3) beibehält, so dass eine Achse des Werkzeugs (2) um ein Gelenk (4) entsprechend der Verkippung des Substrats (3) geneigt wird und daher das Werkzeug (2) und das Substrat (3) aufeinander senkrecht stehen.

2. Positioniereinrichtung nach Anspruch 1, **dadurch gekennzeichnet, dass** die Positioniereinrichtung ein Modell (9) umfasst, mit dem anhand der gemessenen lateralen Kraftkomponenten (Fx) Korrekturwerte (Xcor) für die Sollposition (Xref) des Werkzeugs (2) berechenbar sind.

3. Positioniereinrichtung nach Anspruch 1, **dadurch gekennzeichnet, dass** die Positioniereinrichtung einen Lagekorrekturregler (10) aufweist, mit dem die lateralen Prozesskraftkomponenten (Fx) auf null regelbar sind, indem vom Lagekorrekturregler (10) anhand der gemessenen lateralen Kraftkomponenten (Fx) Korrekturwerte (Xcor) für die Sollposition (Xref) des Werkzeugs (2) erregelbar sind.

4. Positioniereinrichtung nach einem der vorhergehenden Ansprüche, **dadurch gekennzeichnet, dass** das Gelenk (4) Kräfte in allen Richtungen (X, Y, Z), aber keine Drehmomente überträgt.

5. Positioniereinrichtung nach Anspruch 4, **dadurch gekennzeichnet, dass** das Gelenk (4) ein luftgelagertes Kugelgelenk ist.

6. Positioniereinrichtung nach Anspruch 4 oder 5, **dadurch gekennzeichnet, dass** der Werkzeughalter (1) das Gelenk (4) umfasst.

7. Verwendung einer Positioniereinrichtung nach einem der vorhergehenden Ansprüche zum Verbinden einer elektronischen Komponente mit dem Substrat (3) mittels eines Lots, **dadurch gekennzeichnet, dass** die Sollposition (Xref) des Werkzeugs (2) zur Minimierung der lateralen Prozesskräfte (Fx) korrigiert wird, noch bevor sich das Lot verflüssigt.

## Claims

1. Positioning device for positioning a tool (2) at a specified position (Xref) on a two-dimensional substrate (3) in an X-Y plane, which tool exerts a process force (F) in its axial direction (Z) at right angles to the substrate (3), wherein the positioning device is embodied in a portal design, having two parallel linear guides (FX1, FX2) having integrated linear drives that each hold an X carriage (LX1, LX2) so that it is mobile in a first direction (X), and having a crossbar (FY), connected to the two X carriages (LX1, LX2), that holds a Y carriage (LY) so that it is mobile in the second direction (Y), which is perpendicular to the first direction (X), by means of an integrated linear drive, and having a tool holder (1) that is guided on the Y carriage (LY) in the direction (Z), which is perpendicular to the first and second directions (X, Y), and carries the tool (2) for working on the substrate (3) arranged in the X-Y plane, **characterized in that** the tool (2) is equipped with a multicomponent force sensor (5) for measuring unwanted process force components (Fx) in the lateral direction (X, Y) that arise as a result of a slight tilt of the substrate (3) relative to its specified orientation parallel to the X-Y plane, and **in that** the specified position (Xref) of the tool (2) is corrigible by compensating movements of the linear drives of the positioning device such that the lateral process force components (Fx) are minimized, wherein, during the compensating movements, a tool tip maintains its position on the substrate (3), so that an axis of the tool (2) is inclined about a joint (4) in accordance with the tilt of the substrate (3), and therefore the tool (2) and the substrate (3) are at right angles to one another.

2. Positioning device according to Claim 1, **characterized in that** the positioning device comprises a model (9) by means of which correction values (Xcor) for the specified position (Xref) of the tool (2) are calculable on the basis of the measured lateral force components (Fx).

3. Positioning device according to Claim 1, **characterized in that** the positioning device has a position correction controller (10) by means of which the lateral process force components (Fx) are adjustable to zero by virtue of correction values (Xcor) for the specified position (xref) of the tool (2) being adjustable by the position correction controller (10) on the basis of the measured lateral force components (Fx).

4. Positioning device according to one of the preceding claims, **characterized in that** the joint (4) transmits forces in all directions (X, Y, Z), but no torques.

5. Positioning device according to Claim 4, **characterized in that** the joint (4) is an air-cushioned ball joint.

6. Positioning device according to Claim 4 or 5, **characterized in that** the tool holder (1) comprises the joint (4).

7. Use of a positioning device according to one of the preceding claims for connecting an electronic component to the substrate (3) by means of a solder, **characterized in that** the specified position (Xref) of the tool (2) is corrected to minimize the lateral process forces (Fx) even before the solder liquefies.

## Revendications

1. Dispositif de positionnement permettant de positionner un outil (2) dans une position théorique (Xref) sur un substrat plan (3) dans un plan X-Y, lequel outil exerce une force de traitement (F) perpendiculaire sur le substrat (3) dans sa direction axiale (Z), dans lequel le dispositif de positionnement est réalisé sous forme de portique, comportant deux guides linéaires parallèles (FX1, FX2) dotés d'entraînements linéaires intégrés, qui maintiennent chacun un chariot X respectif (LX1, LX2) mobile dans une première direction (X), et comportant une traverse (FY) reliée aux deux chariots X (LX1, LX2), qui maintient un chariot Y (LY) mobile dans la deuxième direction (Y) perpendiculairement à la première direction (X) au moyen d'un entraînement linéaire intégré, et comportant un porte-outil (1) qui est guidé sur le chariot Y (LY) dans la direction (Z) perpendiculaire aux première et deuxième directions (X, Y) et qui porte l'outil (2) pour l'usinage du substrat (3) disposé dans le plan X-Y, **caractérisé en ce que** l'outil (2) est équipé d'un capteur de force multi-composantes (5) permettant de mesurer des composantes de force de traitement (Fx) indésirables dans la direction latérale (X, Y), qui sont provoquées par un léger basculement du substrat (3) par rapport à sa position théorique parallèle au plan X-Y,
et **en ce que** la position théorique (Xref) de l'outil (2) peut être corrigée par des mouvements de compensation des entraînements linéaires du dispositif de positionnement de sorte que les composantes de force de traitement (Fx) latérales soient réduites au minimum, dans lequel, pendant les mouvements de compensation, une pointe d'outil maintient sa position sur le substrat (3) de sorte qu'un axe de l'outil (2) soit incliné autour d'une articulation (4) en fonction du basculement du substrat (3) et que, par conséquent, l'outil (2) et le substrat (3) soient perpendiculaires l'un à l'autre.

2. Dispositif de positionnement selon la revendication 1, **caractérisé en ce que** le dispositif de positionnement comprend un modèle (9) à l'aide duquel des valeurs de correction (Xcor) de la position théorique (Xref) de l'outil (2) peuvent être calculées sur la base des composantes de force (Fx) latérales mesurées.

3. Dispositif de positionnement selon la revendication 1, **caractérisé en ce que** le dispositif de positionnement comprend un régulateur de correction de position (10) à l'aide duquel les composantes de force de traitement (Fx) latérales peuvent être régulées à zéro, des valeurs de correction (Xcor) de la position théorique (Xref) de l'outil (2) pouvant être générées par le régulateur de correction de position (10) sur la base des composantes de force (Fx) latérale mesurées.

4. Dispositif de positionnement selon l'une des revendications précédentes, **caractérisé en ce que** l'articulation (4) transmet des forces dans toutes les directions (X, Y, Z) mais aucun couple.

5. Dispositif de positionnement selon la revendication 4, **caractérisé en ce que** l'articulation (4) est une articulation à rotule à support pneumatique.

6. Dispositif de positionnement selon la revendication 4 ou 5, **caractérisé en ce que** le porte-outil (1) comprend l'articulation (4).

7. Utilisation d'un dispositif de positionnement selon l'une des revendications précédentes pour lier un composant électronique au substrat (3) au moyen d'une soudure, **caractérisé en ce que** la position théorique (Xref) de l'outil (2) est corrigée afin de réduire au minimum les forces de traitement (Fx) latérales avant que la soudure se liquéfie.
